# EUROPEAN PATENT APPLICATION

(11) **EP 4 407 662 A1**
(43) Date of publication of application: **31.07.2024**
(21) Application number: 23157199.3
(22) Date of filing: 17.02.2023
(51) Int. Cl.: H01L 21/67, H01L 21/683, H01L 23/00

(54) **BONDING TOOL OF FLIP CHIP LASER BONDING APPARATUS**

(30) Priority: 27.01.2023 KR 20230010665
(71) Applicant: Mi Equipment Korea Co., Ltd, Pyeongtaek-si, Gyeonggi-do 17708 (KR)
(72) Inventor: KANG, Hyun Gu, Gyeonggi-do 18151 (KR)
(74) Representative: Serjeants LLP

(57) **Abstract**

Disclosed is a bonding tool (10) for simultaneously heating a semiconductor chip using a laser and bonding the semiconductor chip in a flip chip laser bonding process, in which a vacuum wall (W) configured to maintain a vacuum at a time of adsorbing the semiconductor chip is formed at the outer parts of the bottom surface of the bonding tool (10), and a plurality of contact protrusions (E1-E6) is formed lengthwise and breadthwise (or widthwise) on the bottom surface of the bonding tool (10) in a pattern configured such that a heat transfer area of the semiconductor chip to the bonding tool (10) at the center of the semiconductor chip is relatively large and the heat transfer area is gradually reduced in the direction towards the outer parts of the semiconductor chip so as to achieve a uniform temperature distribution from the center to the outer parts of the semiconductor chip.

## Description

### BACKGROUND OF THE INVENTION

### Field of the Invention

The present invention relates to a bonding tool which radiates a laser beam in the state in which a semiconductor chip is pressed in a flip chip laser bonding process, and more particularly, to a bonding tool which may improve bonding quality by uniformly distributing heat generated during a bonding process due to laser transmission to the entire area of a semiconductor chip in the state in which the semiconductor chip is pressed.

### Description of the Related Art

In general, a flip chip bonding process is performed by causing bumps, referred to as Pb-free or Cu pillars, to go through convection reflow, and heat is applied simultaneously to both a substrate and a semiconductor chip due to the nature of such a reflow method and thus causes unwanted problems. When heat is applied to the substrate, the substrate expands, and thus damages the bumps or a fine circuit layer of the semiconductor chip due to a difference in coefficients of thermal expansion between the semiconductor chip and the substrate, and further causes a defect due to abnormal bonding the semiconductor chip to the substrate caused by warpage of the semiconductor chip, as the most serious problem.

When soldering of any one of thousands to tens of thousands of bumps is not properly performed, a semiconductor chip package may malfunction, and thus, a lot of effort to prevent the bumps from being damaged during the reflow process has been made.

In order to solve these problems, laser-assisted bonding technology has been studied. The reflow process is generally performed for 5-7 minutes, whereas laser-assisted bonding using a laser is performed by applying heat only to a semiconductor chip for a very short time of 1-5 seconds per region. Therefore, the semiconductor chip and the surrounding thereof maintain a high temperature, and the temperature of other regions is relatively low. A time to expose the semiconductor chip to heat is short and a region to which heat is applied is local, and thus, thermal stress applied to the semiconductor chip and bumps is relatively low. Further, equipment used in laser-assisted bonding has a small size which is about 1/7 of the size of conventional convection reflow equipment, and does not require N₂ gas, thus being excellent in terms of space utilization.

Further, since as many bump pads as possible need to be formed in one semiconductor chip so as to achieve semiconductor IC integration and functional diversification, pitches between the bump pads are reduced, and substrates and semiconductor chips are changing so as to keep up with light-weight and multifunctionalization trends. A film-type substrate is being used, the thickness of semiconductor chips is being reduced and the contact area of the semiconductor chip with a substrate is being increased so as to be suitable for high-density mounting, and application of 2.5D/3D packaging is being increased.

When a semiconductor chip is bonded to a substrate by radiating a laser beam without pressing the semiconductor chip, a defect may occur even with small bends even if heat is applied to the semiconductor chip for a short time. Even if heat is locally applied to the semiconductor chip for a short time, deterioration of bonding quality due to bending of the substrate and the semiconductor chip is caused unless the semiconductor chip is pressed down with precision.

For this reason, a bonding tool which presses a semiconductor chip while transmitting a laser beam is required. The temperature of the semiconductor chip is rapidly increased simultaneously with absorbing energy oscillating from the laser beam, and the bonding tool must be able to have a function of pressing the semiconductor chip and a function of smoothing bends of the semiconductor chip through vacuum adsorption so as to solve warpage and bending of the substrate and the semiconductor chip. Further, the bonding tool must have excellent laser transmittance.

Further, heat from the semiconductor chip, which is primarily heated by absorbing the energy from the laser beam transmitted by the bonding tool, is returned to the bonding tool, and such heat transfer is changed depending on the shape of the semiconductor chip or surrounding structures. In order to increase bonding quality, it is most desirable that a uniform temperature distribution be maintained throughout the entirety of the area of the semiconductor chip.

As the related art, the applicant of the present invention has developed "a semiconductor chip bonding device using a laser" disclosed in Patent Document 1 and, in addition, "a method of bonding a semiconductor chip" disclosed in Patent Document 2 presents technology in which a thermal heating source in a bonding tool is excluded, the bonding tool is used only as a unit to compress a semiconductor chip against a substrate, and a laser emitter (i.e., a laser generator) disposed above the bonding tool is employed as a heating source to fuse conductive bumps of the semiconductor chip onto the substrate, and the bonding tool must be formed of a material for optical windows, which includes quartz or sapphire single crystals which may physically press a semiconductor chip while transmitting a laser beam and a wavelength from a non-contact thermometer.

Furthermore, as conventional technology related to semiconductor chip bonding apparatuses using a laser, "a laser optic device for laser compression-type flip chip bonding" is disclosed in Patent Document 3, and "a flip chip bonding method" is disclosed in Patent Document 4.

When the above-described optical window is used and high-temperature heat and pressure are applied to the optical window, the optical window has durability that is not low compared to general optical glass, but needs to press the upper surface of a semiconductor chip at force of 3-500 N and thus requires very high rigidity, and the optical window must come into direct contact with the semiconductor chip so as to press the semiconductor chip. In this case, immediately after radiating a laser beam to the upper surface of the semiconductor chip through the surface of the bonding tool coming into contact with the semiconductor chip, heat conduction to the surface of the optical window coming into direct contact with the semiconductor chip occurs depending on the thermal conductivity of the material of the optical window, and heat is moved downwards to a substrate from the semiconductor chip through bumps depending on the shape of the optical window, and is rapidly transferred upwards to the bonding tool. Therefore, in general, the center of the semiconductor chip has a high temperature, and the outer parts of the semiconductor chip have a relatively low temperature. When the laser beam is radiated to the semiconductor chip and thus the semiconductor chip absorbs energy from the laser beam, the temperature of the semiconductor chip is raised and simultaneously, heat is moved from the semiconductor chip to the optical window and the substrate, and a significant portion of the heat is transferred through the contact surface between the optical window and the semiconductor chip. Due to such heat transfer to the bonding tool, there are drawbacks, such as difficulty in raising the temperature of the semiconductor chip and difficulty in uniformizing the temperature of the semiconductor chip. For these reasons, when the bonding tool comes into directly contact with the entire area of the semiconductor chip so as to press the semiconductor chip, many variables occur depending on the thermal conductivity and thermal resistivity of the bonding tool. Thermal conductivity is the intrinsic value of each medium, and thermal resistivity is related to the shape of the bonding tool. That is, based on the second law of thermodynamics, heat always moves from hotter objects to colder objects, and all substances tend to maintain thermal equilibrium.

Sapphire used as the optical window and having the chemical formula Al₂O₃ forms colorless or white crystals, and has a laser transmission wavelength range of 0.17-5.5 um, a melting point of 2040 °C, Knoop hardness of 1900 kg/mm², and a heat transfer rate of 27.21 Wm⁻¹K⁻¹ at 323 K. On the contrary, quartz forms colorless or white crystals, and has a laser transmission wavelength range of 0.4-3 um, a melting point of 1710 °C, Knoop hardness of 741 kg/mm², and a heat transfer rate of 10.7 Wm⁻¹K⁻¹ at 323 K, and quartz has durability and laser transmittance suitable for thermocompression bonding and thus has excellent optical characteristics. When a laser beam is radiated to a semiconductor chip in the state in which the bonding tool comes into contact with the semiconductor chip, a considerable amount of heat generated from the semiconductor chip by absorbing energy of the laser beam is moved towards the optical window.

The applicant of the present invention in this respect suggests "a bonding tool of flip chip laser bonding equipment" disclosed in Patent Document 5 and, in this case, the lower surface of the bonding tool, i.e., the surface of the bonding tool coming into contact with a semiconductor chip, is configured to have a shape which may reduce a contact area with the semiconductor chip, and may thus interrupt heat transfer from the semiconductor chip to the bonding tool so as to allow the temperature of the semiconductor chip to be raised to a proper temperature (250-400 °C) at the time of bonding the semiconductor chip to a substrate.

Particularly, in Patent Document 5, transfer of heat of the semiconductor chip to the bonding tool at the time of raising the temperature of the semiconductor chip using a laser may be minimized by forming simple grooves lengthwise and breadthwise (or widthwise) in the contact surface of the lower surface of the bonding tool with the semiconductor chip so as to reduce the contact area of the boding tool with the semiconductor chip, but, when the semiconductor chip absorbs thermal energy of the laser beam transmitted by the bonding tool in the state in which the bonding tool comes into contact with the semiconductor chip, the temperature of the semiconductor chip is the highest at the center of the semiconductor chip and is then gradually relatively lowered in the outward direction, and thus, all bumps are not heated and melted at uniform temperature and bonding quality is not uniform.

That is, heat transfer only to the bonding tool located on the semiconductor chip and the substrate located under the semiconductor chip occurs at the center of the semiconductor chip, and the center of the semiconductor chip does not contact outdoor air and thus relatively little heat escapes from the center of the semiconductor chip, contrary to the outer parts of the semiconductor chip exposed to the outside, and thus, a temperature deviation between the center and the outer parts of the semiconductor chip is increased.

### RELATED ART DOCUMENT

### PATENT DOCUMENT

(Patent Document 1) Korean Patent Registration No. 10-1785092 (Registration Date: September 28, 2017)
(Patent Document 2) Korean Patent Laid-open Publication No. 10-2014-0094086 (Publication Date: July 30, 2014)
(Patent Document 3) Korean Patent Registration No. 10-1416820 (Registration Date: July 2, 2014)
(Patent Document 4) Korean Patent Registration No. 10-1143838 (Registration Date: April 24, 2012)
(Patent Document 5) Korean Patent Laid-open Publication No. 10-2023-0009297 (Publication Date: January 17, 2023)

### SUMMARY OF THE INVENTION

Therefore, the present invention has been made in view of the above problems, and it is an object of the present invention to provide a bonding tool having an improved structure which may reduce a contact area of the bonding tool with a semiconductor chip to minimize heat transferred from the semiconductor chip to the bonding tool, and may simultaneously maintain a uniform heat distribution throughout the semiconductor chip from the center to the outer parts thereof, at the time of bonding the semiconductor chip to a substrate using a laser so as to improve bonding quality.

It is another object of the present invention to provide a flip chip laser bonding apparatus having the above-described bonding tool.

In accordance with the present invention, the above and other objects can be accomplished by the provision of a bonding tool of a flip chip laser bonding apparatus, including the bonding tool configured to press a semiconductor chip onto a substrate after fixing the semiconductor chip through vacuum adsorption, a laser generator installed above the bonding tool and configured to radiate a laser beam for bonding between the semiconductor chip and the substrate, and a non-contact thermometer configured to monitor a temperature of a surface of the semiconductor chip, wherein the bonding tool is formed of an optical window including a single crystal material able to transmit a laser wavelength range radiated by the laser generator, and is configured such that a vacuum hole for semiconductor chip adsorption is formed through the bonding tool so as to allow a vacuum supplied from a vacuum unit to pass therethrough, a vacuum wall configured to maintain the vacuum at a time of adsorbing the semiconductor chip is formed at outer parts of a contact surface of the bonding tool with the semiconductor chip, contact protrusions configured to reduce a contact area of the bonding tool with the semiconductor chip so as to control heat transfer from the semiconductor chip to the bonding tool are formed on the contact surface of the bonding tool with the semiconductor chip, and the contact protrusions are formed in a pattern configured such that a heat transfer area of the semiconductor chip to the bonding tool at a center of the semiconductor chip is relatively large and the heat transfer area is gradually reduced in a direction from the center of the semiconductor chip to outer parts of the semiconductor chip so as to achieve a uniform temperature distribution from the center of the semiconductor chip to the outer parts of the semiconductor chip.

The contact protrusions may be independently formed to be spaced apart from corresponding adjacent ones of the contact protrusions, and may be configured such that cross-sectional areas of the contact protrusions formed at a center of the bonding tool are relatively large and the cross-sectional areas of the contact protrusions are gradually reduced as the contact protrusions are closer to outer parts of the bonding tool.

The contact protrusions may be independently formed to be spaced apart from corresponding adjacent ones of the contact protrusions, and may be configured such that cross-sectional areas thereof are the same and spaces between corresponding adjacent ones of the protrusions are gradually increased as the contact protrusions are closer to outer parts of the bonding tool from a center of the bonding tool.

### BRIEF DESCRIPTION OF THE DRAWINGS

The above and other objects, features and other advantages of the present invention will be more clearly understood from the following detailed description taken in conjunction with the accompanying drawings, in which:
FIG. 1 is a front view illustrating an arrangement state between a bonding tool and a laser generator of a laser bonding apparatus according to the present invention;
FIG. 2 is a schematic view illustrating a bonding state between a semiconductor chip and a substrate and a temperature monitoring state through a non-contact thermometer at the time of laser bonding in the present invention;
FIG. 3 is a perspective bottom view of the bonding tool according to the present invention;
FIG. 4 is a bottom view of the bonding tool according to the present invention;
FIG. 5 is a longitudinal-sectional view of the bonding tool according to the present invention; and
FIG. 6 is a bottom view of a bonding tool according to another embodiment of the present invention.

### DETAILED DESCRIPTION OF THE INVENTION

Hereinafter, reference will be made in detail to various embodiments of the present invention, examples of which are illustrated in the accompanying drawings and described below. While the invention will be described in conjunction with exemplary embodiments, it will be understood that the present description is not intended to limit the invention to the exemplary embodiments.

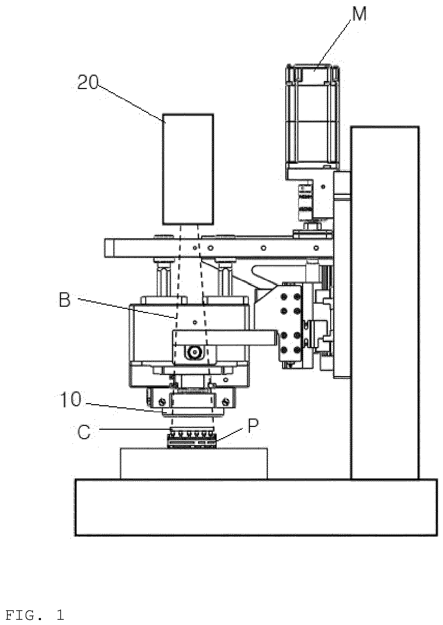

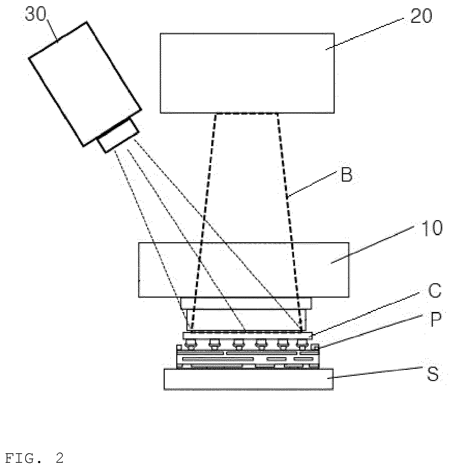

FIG. 1 illustrates an arrangement state between a bonding tool and a laser generator of a laser bonding apparatus according to the present invention, and FIG. 2 illustrates a temperature monitoring state through a non-contact thermometer in the present invention.

As shown in FIGs. 1 and 2, a laser bonding apparatus according to the present invention includes a bonding tool 10 configured to fix a semiconductor chip C through vacuum adsorption and to press the semiconductor chip C onto a substrate P, a laser generator 20 installed above the bonding tool 10 and configured to radiate a laser beam B for bonding between the semiconductor chip C and the substrate P, and a non-contact thermometer 30 (FIG. 2) configured to monitor the temperature of the surface of the semiconductor chip C.

In the drawings, M indicates a rotary servomotor or a linear actuator configured to raise and lower the bonding tool 10 so as to press the semiconductor chip C, S indicates a chuck configured to fix the substrate P, and the substrate P is fixed to the chuck S using vacuum adsorption so that heat may be naturally transferred to the chuck S without any space in a contact surface between the substrate P and the chuck S. Further, the chuck S may preheat the substrate P to a designated temperature before radiating the laser beam B, and thereby, the temperature of the semiconductor chip C may be rapidly raised after radiating the laser beam B.

In the present invention, when the non-contact thermometer 30 employs an infrared thermal imaging camera or a pyrometer, the non-contact thermometer 30 accurately measures the surface temperature of the semiconductor chip C in real time as both the wavelength of the oscillating laser beam B and infrared light I emitted by the semiconductor chip C at the time of bonding the semiconductor chip C to the substrate S simultaneously pass through the bonding tool 10 and reach the non-contact thermometer 30, as shown in FIG. 2, and, in this case, the non-contact thermometer 30 has a measurement range which coincides with or is wider than one position of the laser beam B radiated by the laser generator 20 or the radiation range thereof, and may thus measure a temperature distribution and temperature changes within a laser radiation range in real time and determine the ratio of a contact area of the bonding tool 10 with the semiconductor chip C so as to uniformize the temperature distribution, and therefore, the present invention may provide the bonding tool 10 which measures temperature changes on the surface of the semiconductor chip C in real time during laser oscillation, analyzes whether or not the semiconductor chip C is normally bonded to the substrate P through the temperature changes on the surface of the semiconductor chip C due to thermal change or bends of the semiconductor chip C, and employs the ratio of the contact area of the bonding tool 10 with the semiconductor chip C, optimized to result in high-quality bonding.

When laser oscillation occurs in the state in which the bonding tool 10 comes into contact with the semiconductor chip C, most of the laser beam B is transmitted by the bonding tool 10, the semiconductor chip C absorbs energy of the laser beam B, and heat of the semiconductor chip C is transferred to the bonding tool 10. In such a pressing-type bonding apparatus configured to smooth bends of a semiconductor chip, in order to solve heat transfer due to contact of the bonding tool 10 with the semiconductor chip C, independent contact protrusions E are formed on the contact surface of the bonding apparatus C with the semiconductor chip C as a method of varying the contact area of the bonding tool 10 with the semiconductor chip C depending on a position of the bonding tool 10, thereby reducing the contact rate of the bonding tool 10 and the semiconductor chip C as much as possible while varying the contact area of the bonding tool 10 with the semiconductor chip C depending on the position of the bonding tool 10. Thereby, heat of the semiconductor chip C is not completely transferred to the bonding tool 10, and a part of heat of the semiconductor chip C is transferred to the bonding tool 10 and the remainder is isolated, and thus, the temperature of the semiconductor chip C may be uniformly raised to a temperature required for bonding within a short time without raising the output of the laser beam B, and bonding quality of the semiconductor chip C to the substrate P may be raised.

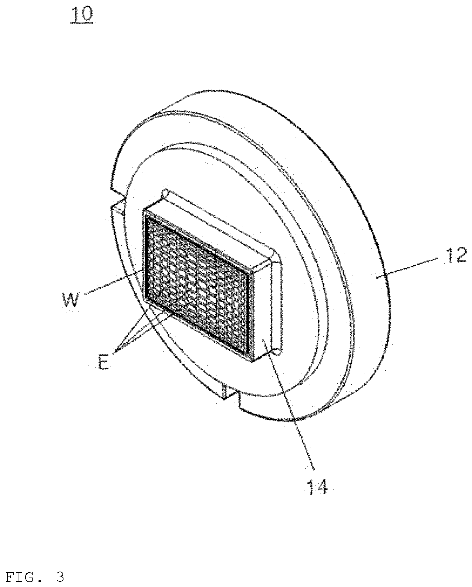

In the present invention, the bonding tool 10 formed of an optical window includes, referring to one embodiment shown in FIGs. 3 to 5, a manifold block 12 connected to a vacuum unit in the same manner as a manifold block used in the conventional laser bonding apparatus, and an attachment unit 14 formed integrally with the bottom surface of the manifold block 12 and configured to fix the semiconductor chip C through vacuum adsorption, the manifold block 12 and the attachment unit 14 are formed of a material which may transmit both the laser beam B emitted by the laser generator 20 and a wavelength range sensed by the non-contact thermometer 30, and a vacuum hole 16 for semiconductor chip adsorption is formed through the manifold block 12 and the attachment unit 14 so that a vacuum supplied from the vacuum unit passes therethrough.

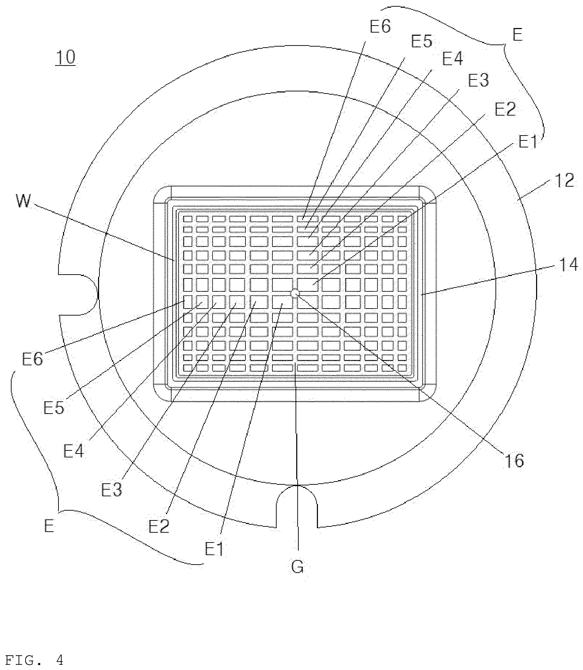

In this embodiment, a plurality of contact protrusions E: E1-E6 are formed lengthwise and breadthwise (or widthwise) on the bottom surface of the attachment unit 14, and a vacuum wall W configured to maintain a vacuum at the time of adsorbing the semiconductor chip 10 onto the bottom surface of the attachment unit 14 is formed at the outer parts of the bottom surface of the attachment unit 14, as shown in FIG. 4.

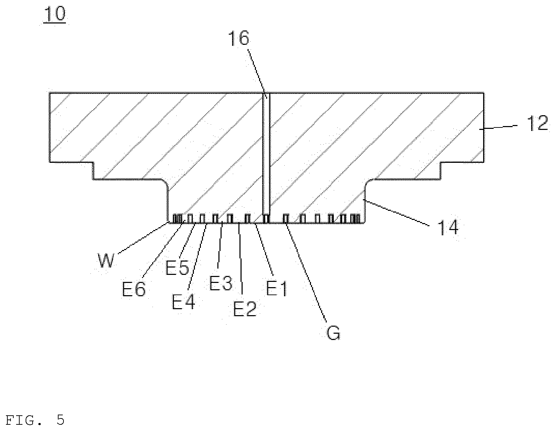

In this embodiment, the contact protrusions E and the vacuum wall W are formed to have the same height, as shown in FIG. 5, and the contact protrusions E are formed in a pattern in which the heat transfer area of the semiconductor chip C to the bonding tool 10 at the center of the semiconductor chip C is relatively large and the heat transfer area is gradually reduced in the direction from the center of the semiconductor chip C to the outer parts of the semiconductor chip C, so as to achieve a uniform temperature distribution from the center of the semiconductor chip C to the outer parts of the semiconductor chip C.

In more detail, the plurality of contact protrusions E1, E2, E3, E4, E5 and E6 formed on the bottom surface of the attachment unit 14 of the bonding tool 10, i.e., the contact surface of the attachment unit 14 with the semiconductor chip C, is independently formed to be spaced apart from corresponding adjacent ones of the contact protrusions E1, E2, E3, E4, E5 and E6, and is configured such that the cross-sectional areas of the contact protrusions E1 formed at the center of the bonding tool 10 are relatively large and the cross-sectional areas of the contact protrusions E2-E6 are gradually reduced as the contact protrusions E2-E6 are closer to the outer parts of the bonding tool 10.

In this embodiment, the plurality of contact protrusions E1-E6 is disposed to be spaced apart from one another by a designated interval in the lengthwise direction and the breadthwise (or widthwise) direction, and may be formed by engraving grooves G on the bottom surface of the bonding tool 10 to a designated depth except for regions for the contact protrusions E1-E6, and a microelectromechanical system (MEMS) method, a laser machining method, or a chemical etching method may be used to form the contact protrusions E1-E6.

In this embodiment, the contact protrusions E1-E6 are formed in a quadrangular column shape having a designated height, and the tips of the contact protrusions E1-E6, i.e., the contact surfaces of the contact protrusions E1-E6, are flat so as to come into contact with the semiconductor chip.

Although this embodiment describes the contact protrusions E1-E6 having a rectangular cross section, as shown in the accompanying drawings, the present invention is not limited thereto, and the contact protrusions E1-E6 may be formed to have a square cross section and, in order to improve durability of the contact protrusions E1-E6, the outer parts of the respective contact protrusions E1-E6 are preferably filleted or chamfered so as to prevent the corners or the edges of the contact protrusions E1-E6 from being damaged, i.e., being broken or cracked due to impact, in spite of frequent contact with semiconductor chips.

The gradual reduction ratio of the cross-sectional areas of the above-described contact protrusions E1-E6, i.e., the reduction ratio of the cross-sectional areas of the above-described contact protrusions E1-E6 as the contact protrusions E are closer to the outer parts of the bonding tool 10 from the center of the bonding tool 10, is designed in consideration of a temperature difference changed in the direction from the center of the semiconductor chip C heated by radiating the laser beam B to the semiconductor chip C to the outer parts of the semiconductor chip C, and thereby, a uniform heat distribution throughout the semiconductor chip C from the center to the outer parts thereof may be maintained.

Further, since a heat transfer rate from the semiconductor chip C to the bonding tool 10 is varied depending on the width and depth of the grooves G formed at positions between the contact protrusions E1-E6, it is necessary to design the contact protrusions E1-E6 in view of this, and it is necessary to minimize transfer of heat by designing the contact protrusions E1-E6 to be as small as possible so that the area of the contact protrusions E1-E6 other than the grooves G, i.e., the contact area of the bonding tool 10 with the semiconductor chip C, is within the range of 70%-10%. Put another way, if the contact surface of the bonding tool 10 is defined by a footprint, the contact area between the contact protrusions E1-E6 and the semiconductor chip may be about 70%-10% of the footprint.

In this embodiment, the grooves G are formed to have the same width in the horizontal and vertical directions from the center to the outer parts of the bonding tool 10, the contact protrusions E1-E6 are formed in a pattern in which the contact protrusions E1-E6 arranged in the horizontal direction have the same vertical width and horizontal widths which are gradually reduced as the contact protrusions E1-E6 are closer to the outer parts of the bonding tool 10 from the center of the bonding tool 10, and the contact protrusions E1-E6 arranged in the vertical direction have the same horizontal width and vertical widths which are gradually reduced as the contact protrusions E1-E6 are closer to the outer parts of the bonding tool 10 from the center of the bonding tool 10.

Further, such changes, i.e., gradual reductions, in the cross-sectional areas of the contact protrusions E1-E6 are made not only in the horizontal and vertical directions but also in the diagonal directions. Since the outer parts of the attachment unit 14 in the diagonal directions are farther from the center of the attachment unit 10 than the outer parts of the attachment unit 14 in the horizontal and vertical directions, the cross-sectional areas of the contact protrusions E1-E6 arranged in the diagonal directions are gradually reduced at a higher ratio than the contact protrusions E1-E6 arranged in the horizontal and vertical directions as both the horizontal widths and the vertical widths of the contact protrusions E1-E6 arranged in the diagonal directions are gradually reduced, and thereby, the outermost contact protrusions in the diagonal directions have the minimum cross-sectional area.

Although this embodiment describes the contact protrusions E1-E6 formed in a quadrangular column shape and arranged in lines in the vertical and horizonal directions, the present invention is not limited thereto, and the contact protrusions may be formed in other shapes, such as a rhombic column shape, a diamond column shape or a cylindrical shape, and may be arranged to be spaced apart from one another by a designated interval in the diagonal directions or radially.

Actually, the inventors of the present invention conducted bonding tests of semiconductor chips under the same conditions, i.e., at the same laser beam output and for the same radiation time, using a conventional bonding tool having a flat contact surface without any contact protrusions, the bonding tool disclosed in Patent Document 5, and the bonding tool according to this embodiment. As results of the tests, when conditions for laser oscillation power and time were set so that the temperature of the center of the semiconductor chip could be raised to 350 °C on the assumption that the melting temperature of solder is generally 220-400 °C even if the bonding temperature of the semiconductor chip may be varied depending on the kind of the semiconductor chip, the conventional flat bonding tool without any contact protrusions required relatively high laser output to raise the temperature of the semiconductor chip to 350 °C and exhibited a temperature variation of 150 °C at maximum between the center of the semiconductor chip and the outer parts of the semiconductor chip in the diagonal directions, the bonding tool disclosed in Patent Document 5 raised the temperature of the semiconductor chip to 350 °C even when low laser output was radiated to the semiconductor chip compared to the conventional flat bonding tool and exhibited a temperature variation of 100 °C at maximum between the center of the semiconductor chip and the outer parts of the semiconductor chip in the diagonal directions, the bonding tool according to this embodiment required similar laser output to the bonding tool disclosed in Patent Document 5 to raise the temperature of the semiconductor chip to 350 °C and exhibited a temperature variation of only 40 °C at maximum between the center of the semiconductor chip and the outer parts of the semiconductor chip in the diagonal directions, and thereby, it may be confirmed that the temperature variation between the center and the outer parts of a semiconductor chip may be minimized by varying the cross-sectional areas of the contact protrusions between the center and the outer parts of the bonding tool, i.e., by gradually reducing the contact areas of the contact protrusions with the semiconductor chip in a direction from the center to the outer parts of the bonding tool.

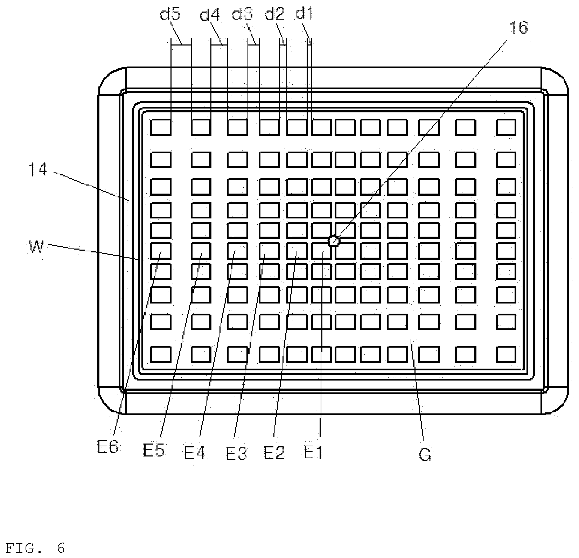

Further, FIG. 6 illustrates a bonding tool according to another embodiment of the present invention and, in this embodiment, a uniform temperature distribution throughout a semiconductor chip may be maintained by gradually increasing spaces d1-d5 between contact protrusions E1-E6 as the contact protrusions E1-E6 are closer to the outer parts of the bonding tool from the center of the bonding tool, instead of the gradual reductions in the cross-sectional areas of the contact protrusions E1-E6 as the contact protrusions E1-E6 are closer to the outer parts of the bonding tool from the center of the bonding tool.

That is, in this embodiment, by configuring the contact protrusions E1-E6 such that the cross-sectional areas thereof are the same and the spaces d1-d5 between corresponding adjacent ones of the protrusions E1-E6 are gradually increased as the contact protrusions E1-E6 are closer to the outer parts of the bonding tool from the center of the bonding tool, a large amount of heat is transferred to the bonding tool from the center of the semiconductor chip heated by a radiated laser beam, which has a relatively high temperature, and heat transfer to the bonding tool from the outer parts of the semiconductor chip, which have a relatively low temperature, is minimized, and thereby, heat distribution on the semiconductor chip from the center to the outer parts thereof may be uniformly maintained.

In this embodiment, the contact protrusions E1-E6 are formed such that the spaces d1-d5 between the contact protrusions E1-E6 in the horizontal direction and the vertical direction are gradually increased in the direction from the center to the outer parts of the bonding tool, and thereby, the density of the contact protrusions at the center of the bonding tool is high and the density of the contact protrusions is gradually reduced as the contact protrusions are closer to the outer parts of the bonding tool tool from the center of the bonding tool, and consequently, the bonding tool absorbs a relatively large amount of heat from the center of the semiconductor chip, which has a relatively high temperature, and absorbs a relatively small amount of heat from the outer parts of the semiconductor chip, which have a relatively low temperature, due to changes in the contact area with the semiconductor chip, thereby achieving a uniform thermal distribution and improving bonding quality.

In the same manner as the above-described first embodiment, in this embodiment, changes in the density of the contact protrusions in the diagonal directions are larger than changes in the density of the contact protrusions in the horizontal and vertical directions from the center of the bonding tool, and thereby, heat transfer to the bonding tool from the outer parts of the semiconductor chip in the diagonal directions, which are farther from the center of the semiconductor chip than the outer parts of the semiconductor chip in the horizontal and vertical directions, is further reduced.

Although not shown in the drawings, through a combination of the above-described two embodiments, i.e., by gradually reducing the cross-sectional areas of the contact protrusions from the center to the outer parts of the bonding tool and gradually increasing the spaces between the contact protrusions from the center to the outer parts of the bonding tool, the thermal distribution on the semiconductor chip may become more uniform.

As is apparent from the above description, at least one embodiment of the present invention provides a bonding tool of a flip chip laser bonding apparatus, in which contact protrusions configured to minimize heat movement (heat transfer or heat loss) are formed in a designated pattern on the contact surface of the bonding tool with a semiconductor chip so as to raise the temperature of the semiconductor chip to a temperature required to bond the semiconductor chip to a substrate without laser oscillation at a high power and thus to achieve energy reduction, and the contact protrusions form a uniform temperature distribution throughout the semiconductor chip at the time of raising the temperature of the semiconductor chip so as to improve bonding quality of the semiconductor chip.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A bonding tool (10) of a flip chip laser bonding apparatus, the bonding tool (10) configured to press a semiconductor chip (C) onto a substrate (P) and to fix the semiconductor chip (C) through vacuum adsorption,
wherein the bonding tool (10) is formed of an optical window comprising a single crystal material able to transmit a laser wavelength range radiated by a laser generator (20) of the flip chip laser bonding apparatus, and is configured such that a vacuum hole (16) for semiconductor chip adsorption is formed through the bonding tool so as to allow a vacuum supplied from a vacuum unit to pass therethrough,
wherein a vacuum wall (W) configured to maintain the vacuum at a time of adsorbing the semiconductor chip (C) is formed at outer parts of a contact surface of the bonding tool (10) with the semiconductor chip (C), and
wherein contact protrusions (E1-E6) configured to reduce a contact area of the bonding tool (10) with the semiconductor chip (C) so as to control heat transfer from the semiconductor chip (C) to the bonding tool (10) are formed on the contact surface of the bonding tool (10) with the semiconductor chip (C), the contact protrusions (E1-E6) being formed in a pattern configured such that a heat transfer area of the semiconductor chip (C) to the bonding tool (10) at a center of the semiconductor chip (C) is a maximum and the heat transfer area is gradually reduced in a direction from the center of the semiconductor chip (C) to outer parts of the semiconductor chip (C) so as to achieve a uniform temperature distribution from the center of the semiconductor chip (C) to the outer parts of the semiconductor chip (C).

2. The bonding tool (10) according to claim 1, wherein the contact protrusions (E1-E6) are independently formed to be spaced apart from corresponding adjacent ones of the contact protrusions (E1-E6), and are configured such that cross-sectional areas of the contact protrusions (E1-E6) formed at a center of the bonding tool (10) are a maximum and the cross-sectional areas of the contact protrusions (E1-E6) are gradually reduced as the contact protrusions (E1-E6) are closer to outer parts of the bonding tool (10).

3. The bonding tool (10) according to claim 1, wherein the contact protrusions (E1-E6) are independently formed to be spaced apart from corresponding adjacent ones of the contact protrusions (E1-E6), and are configured such that cross-sectional areas thereof are the same and spaces (d1-d5) between corresponding adjacent ones of the contact protrusions (E1-E6) are gradually increased as the contact protrusions (E1-E6) are closer to outer parts of the bonding tool (10) from a center of the bonding tool (10) .

4. The bonding tool (10) according to claim 1, wherein the contact protrusions (E1-E6) are independently formed to be spaced apart from corresponding adjacent ones of the contact protrusions (E1-E6), and are configured such that spaces (d1-d5) between corresponding adjacent ones of the protrusions (E1-E6) are gradually increased as the contact protrusions (E1-E6) are closer to outer parts of the bonding tool (10) from a center of the bonding tool (10), and cross-sectional areas of the contact protrusions (E1-E6) are gradually reduced as the contact protrusions (E1-E6) are closer to the outer parts of the bonding tool (10) from the center of the bonding tool (10).

5. The bonding tool (10) according to claim 2 or claim 4, wherein a reduction ratio of the cross-sectional areas of the contact protrusions (E1-E6) as the contact protrusions (E1-E6) are closer to the outer parts of the semiconductor chip (C) from the center of the bonding tool (10) is proportional to a temperature difference changed in the direction from the center of the semiconductor chip (C), heated by radiating the laser beam, to the outer parts of the semiconductor chip (C).

6. The bonding tool (10) according to claim 2 or claim 4, wherein the contact protrusions (E1-E6) have a rectangular cross section, and are formed in a pattern configured such that the contact protrusions (E1-E6) arranged in a horizontal direction have the same vertical width and horizontal widths are gradually reduced as the contact protrusions (E1-E6) are closer to the outer parts of the bonding tool (10) from the center of the bonding tool (10), and the contact protrusions (E1-E6) arranged in a vertical direction have the same horizontal width and vertical widths are gradually reduced as the contact protrusions (E1-E6) are closer to the outer parts of the bonding tool (10) from the center of the bonding tool (10) .

7. The bonding tool (10) according to claim 6, wherein gradual reductions in the cross-sectional areas of the contact protrusions (E1-E6) are made not only in the horizontal and vertical directions but also in diagonal directions, and the cross-sectional areas of the contact protrusions (E1-E6) arranged in the diagonal directions are gradually reduced at a higher ratio than the contact protrusions (E1-E6) arranged in the horizontal and vertical directions as both the horizontal widths and the vertical widths of the contact protrusions (E1-E6) arranged in the diagonal directions are gradually reduced.

8. The bonding tool (10) according to any one of the preceding claims, wherein a contact area between the contact protrusions (E1-E6) and the semiconductor chip (C) is 70%-10% of the footprint of the contact surface of the bonding tool (10).

9. The bonding tool (10) according to any one of the preceding claims, wherein the contact protrusions (E1-E6) have a circular or polygonal cross section.

10. A flip chip laser bonding apparatus comprising the bonding tool (10) according to any one of the preceding claims.

11. The flip chip laser bonding apparatus according to claim 10, further comprising:
a laser generator (20) installed above the bonding tool (10) and configured to radiate a laser beam for bonding between the semiconductor chip (C) and the substrate (P), and
a non-contact thermometer (30) configured to monitor a temperature of a surface of the semiconductor chip (C).
